# EUROPEAN PATENT APPLICATION

(11) **EP 4 306 674 A1**
(43) Date of publication of application: **17.01.2024**
(21) Application number: 22185268.4
(22) Date of filing: 15.07.2022
(51) Int. Cl.: C23C 14/24, C23C 14/06, C23C 14/12, H10K 71/16, H10K 85/50

(54) **METHOD OF PREPARING PEROVSKITE STRUCTURES**

(71) Applicant: Evolar AB, 756 51 Uppsala (SE)
(72) Inventor: LARSSON, Fredrik, 756 50 UPPSALA (SE); WALLIN, Erik, 755 98 UPPSALA (SE); LUNDBERG, Olle, 752 60 UPPSALA (SE)
(74) Representative: Brann AB

(57) **Abstract**

The present invention relates to a method of preparing a perovskite structure on a substrate surface wherein the perovskite has a general structure of ABX₃ where A is at least partly an organic compound and where the method uses a source for the organic compound which does not contain a halide. Improved photovoltaic properties of the obtain perovskite is obtained and the method allows for large scale production.

## Description

### FIELD OF THE INVENTION

The present invention relates to a method and an apparatus for preparing a perovskite structure having the general structure ABX₃ on a substrate where A is at least partly an organic compound where the method and the apparatus used two different sources of the organic compound. The method and the apparatus may be used to prepare solar cells.

### BACKGROUND

Perovskite semiconductor thin films are most commonly made using solution-based methods. High efficiencies have been achieved for solar cells made from such perovskite materials but there are some particular difficulties with solution-based methods which makes them less suitable for industrial use. One is difficulties in upscaling to the large area high throughput processes required for mass-production, other difficulties are related to the usage of solvents. The solvent has to be removed and residues could remain potentially causing electrically active defects, either from impurities or from the formation of internal surfaces related to porosity. One thin film deposition method that already have been demonstrated in mass-production of semiconducting thin films is vacuum evaporation. Vacuum evaporation is truly additive in its nature, and films with very high purity can be obtained. On the other hand, vacuum evaporation of multicomponent thin films requires very precise control of the vapor fluxes of the different components.

The most commonly used perovskite materials for solar cells have compositions that can be written ABX₃. A, B and X will take specific lattice positions in the perovskite crystal structure. A is typically an organic molecule such as methylammonium (MA) or formamidinium (FA), or mixture of these two, or a mixture of the organic molecules and Cs. Other elements are also conceivable but Cs is the most commonly used one. In all perovskite to date that results in solar cells with high efficiency (> 20 %) B is Pb. X is I or a mixture of I and Br, or possibly CI. Thus many high performance perovskites have the general chemical formula (MA, FA, Cs)Pb(I, Br)₃.

When such films are made by evaporation, a typical set of evaporation sources would be one with formamidinium iodide (FAI), one with PbI₂ (lead iodide), and one with CsBr (caesium bromide). Optionally, there could also be a source with methylammonium iodide (MAI).

However, there is still a need for more efficient and more controlled methods in order to enable scale up of the fabrication method to mass-production.

### SUMMARY OF INVENTION

The object of the present invention is to overcome the drawbacks of the prior art by providing a method and an apparatus for preparing perovskite films which facilitates both control of the structure formation and large scale production.

In a first aspect the present invention relates to a method according to claim 1.

In a second aspect the present invention relates to an apparatus for preparing a perovskite structure (10) on a substrate surface (11) wherein the perovskite has a general structure of ABX₃ where component A is an organic molecule or a mixture of organic molecules, or wherein A is caesium, potassium and/or rubidium or a mixture of an organic molecule and caesium, potassium and/or rubidium, component B is lead and/or tin and component X is a halide,
and wherein the apparatus comprises a vacuum chamber (12) comprising a substrate inlet (14) and a substrate outlet (16);
wherein the vacuum chamber comprises at least one deposition zone (18) wherein at least a first (20) and a second evaporation source (22) of the components are arranged, wherein the first evaporation source (20) comprises component A-X, the second evaporation source (22) comprises component B-X;
wherein a third source is provided wherein the third source is either a third evaporation source (24) comprising component A as a salt provided in the deposition zone (18) or in an evaporation reactor (26) in vapour connection with the deposition zone of the vacuum chamber, or wherein the third source is an external source (28) containing a gas comprising component A provided in vapour connection with the deposition zone, and wherein the salt comprises the organic molecule or mixture of organic molecules as the cation and wherein the anion is not a halide and wherein the gas contained in the external source (28) comprises formamidine, formamidinium, methylammonium or methylamine; and wherein the vacuum chamber (12) and the optional evaporation reactor (26) comprise a heating device (29) configured to heat the evaporation sources individually at a reduced pressure to vaporize the components and to create a flow of said components, and wherein the vacuum chamber is configured to bring the flow into contact with the substrate surface.

### BRIEF DESCRIPTION OF THE FIGURES

**Figure 1****.** Process pressure for different depositions time, with or without FAAc (formamidine acetate) supply during the co-evaporation process (triangular or circular data points, respectively).
**Figure 2****.** PCE for perovskite solar cell devices (A = 0.126 cm²) determined by IV measurements performed under standard test conditions using a Class AAA sun simulator.

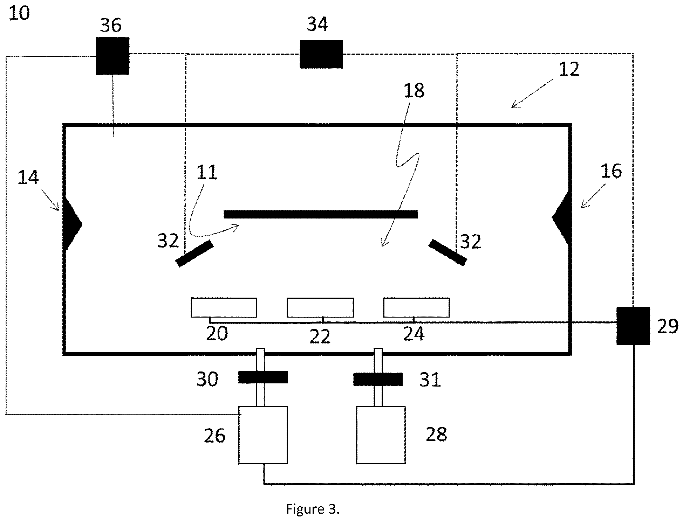

**Figure 3****.** Schematic illustration of the apparatus according to the present invention. Dotted lines illustrates communication.

### ITEMIZED EMBODIMENTS

A non-limiting list of embodiments are disclosed here below.

In one embodiment of any of the aspects of the present invention the component A-X and B-X of the first and second evaporation sources respectively are solid, preferably in the form of a powder, when heated.

In one embodiment of any of the aspects of the present invention the component A-X of the first evaporation source is selected from formamidinium iodide, formamidinium bromide, formamidinium chloride, methylammonium iodide, methylammonium bromide or methylammonium chloride or a combination of two or more thereof.

In one embodiment of any of the aspects of the present invention the component B-X of the second evaporation source is selected from lead iodide (PbI₂), lead bromide (PbBr₂) or lead chloride (PbCl₂) or a combination of two or more thereof, or from tin iodide (SnI₂ or SnI₄), tin bromide (SnBr₂ or SnBr₄) or tin chloride (SnCl₂ or SnCl₄) or a combination of two or more thereof.

In one embodiment of any of the aspects of the present invention the third evaporation source is provided and comprises component A as a salt wherein the anion is selected from acetate, formate, tetrafluoroborate, hexafluorophosphate and thiocyanate, and wherein the salt is preferably selected from formamidinium acetate or methylammonium acetate or a combination thereof and wherein the salt preferably is in the form of a powder.

In one embodiment of any of the aspects of the present invention the external source is provided containing a gas comprising component A and wherein the gas is purified prior to entering the deposition zone.

In one embodiment of any of the aspects of the present invention the invention comprises providing a fourth evaporation source wherein the fourth evaporation source comprises component A-X wherein A is caesium, potassium and/or rubidium, wherein A-X is preferably selected from caesium-acetate, caesium-formate, caesium iodide (Csl) and caesium bromide (CsBr) and evaporating the component of the fourth evaporation source at the reduced pressure by heating the fourth evaporation source to create a flow of said components and bringing the flow of the evaporated components into contact with the substrate surface in the deposition zone and allowing the components to form a perovskite structure on said surface.

In one embodiment of any of the aspects of the present invention the reduced pressure in the deposition zone is lower than 1×10⁻⁴mbar.

In one embodiment of any of the aspects of the present invention the substrate has a multi-layered structure including preferred layers such as transparent conductive oxides (TCO) and hole or electron transport layers.

In one embodiment of any of the aspects of the present invention the third evaporation source is arranged in an evaporation reactor in vapour connection with the deposition zone; and wherein the method preferably comprises a step of purifying the flow of the evaporated components from the third evaporation source prior to entering the deposition zone.

In one embodiment of any of the aspects of the present invention the flow of the components is monitored using at least one suitable detector arranged in the deposition zone preferably by using one or more quartz crystal rate detectors or mass spectrometry.

In one embodiment of any of the aspects of the present invention the components of at least the first, the second evaporation sources and preferably also the third evaporation source are co-evaporated.

In one embodiment of any of the aspects of the present invention the substrate has a temperature lower than the temperature of the component in the flow.

In one embodiment of any of the aspects of the present invention the vacuum chamber is configured to enable one or more substrates to enter and exit the vacuum chamber automatically via the substrate inlet (14) and the substrate outlet (16) respectively.

In one embodiment of the second aspects of the present invention the apparatus is configured to enable in-line continuous production of perovskite structures on a substrate surface by enabling the substrate to enter the vacuum chamber via the substrate inlet and to be transferred from said inlet via the deposition zone to a substrate outlet to exit the vacuum chamber.

In one embodiment the second aspects of the present invention the third evaporation source (24) is arranged in an evaporation reactor (26) and wherein the apparatus preferably comprises a purifying device (30) configured to purify the vaporized components from the third evaporation source prior to entering the deposition zone.

In one embodiment of any of the aspects of the present invention an external source (28) containing a gas comprising component A is provided in vapour connection with the deposition zone and wherein the apparatus preferably comprises a purifying device (31) configured to purify the gas prior to entering the deposition zone.

In one embodiment of the second aspect of the present invention the apparatus further comprises at least one detector (32) and a control unit (34) that is operatively connected to the at least one detector (32), wherein the at least one detector (32) is configured to detect or measure at least one property of the apparatus and to transmit signals representing the at least one property to the control unit (34), and wherein the control unit (34) is configured to control at least one of the heating device (29), the pressure device (36) or a flow control device for the evaporation reactor (26) or the external source (28).

In one embodiment the second aspects of the present invention the apparatus comprises a detector (32) wherein said detector (32) is a quartz crystal rate detector.

All the embodiments may be combined unless stated otherwise.

### DETAILED DESCRIPTION

### The method

The method according to the present invention aims at preparing a perovskite structure or a film of a perovskite structure on a substrate surface where the perovskite has the general structure of ABX₃. Component A is selected from an organic molecule, or a mixture of organic molecules, caesium, potassium and/or rubidium, and a mixture of an organic molecule and caesium, potassium and/or rubidium. In one embodiment A is a mixture between an organic molecule and caesium. Component B is lead and/or tin, and X is a halide preferably iodide and/or bromide. In one embodiment the perovskite structure has the structure of A_{1-*x*}Cs*ₓ*Pb_{y}I_{2-*x+y*}Br*ₓ* where *x* is 0.30±0.05 and y is 1.1±0.1 where A is formamidinium or methylammonium. The thickness of the perovskite film on the substrate is preferably in the range of 0.1-2.0µm, more preferably 0.2-1.0µm.

The perovskite structure or perovskite film is prepared through deposition of the components in vapour phase on the substrate surface and where the substrate is arranged in a deposition zone in a vacuum chamber. At least one first and at least one second evaporation source are provided comprising component A-X and B-X respectively and said first and second evaporation sources are preferably arranged in the deposition zone. In one embodiment at least two first evaporation sources are provided, a primary first evaporation source and a secondary first evaporation source. In another embodiment at least two second evaporation sources are provided, a primary second evaporation source and a secondary second evaporation source. The substrate may be mounted or arranged horizontally above or vertically besides the evaporation sources. The components of the first and second evaporation sources are preferably solid and preferably in the form of a powder which is beneficial since it avoids the use of solvents. An additional source, a third source, of component A as the organic molecule or mixture of organic molecules is also provided and in one embodiment said third source is a third evaporation source comprising component A as a salt where the salt comprises the organic molecule or mixture of organic molecules as the cation and wherein the anion is not a halide. By using a salt of A where the anion is not a halide, such as iodide or bromide, it is possible to provide the organic component without also providing additional halide which may disturb or hinder formation of the wanted perovskite structure and composition. A non-limiting list of preferred anions is acetate, formate, tetrafluoroborate, hexafluorophosphate and thiocyanate. The third evaporation source is preferably arranged in the deposition zone or in an evaporation reactor in vapour connection with the deposition zone. In another embodiment the third source is an external source from which component A is provided to the deposition zone as a gas where said gas comprises formamidine, formamidinium, methylammonium or methylamine. An advantage of using an external gas source for component A is that it is possible to provide the organic compound without also providing additional halide and furthermore, the gas may be purified prior to entering the deposition zone and thereby better control of the structure may be obtained as well as better photovoltaic properties of the perovskite layer. A fourth evaporation source may also be provided in the deposition zone or in an evaporation reactor where said fourth evaporation source comprises component A as a cation where A is caesium, potassium and/or rubidium and where the anion preferably is selected from acetate, formate, iodide and bromide. In one preferred embodiment the fourth evaporation source comprises caesium-acetate, caesium-formate, caesium iodide (Csl) and caesium bromide (CsBr). Evaporation of the components of the fourth evaporation source is done as described above at the reduced pressure and preferably by heating.

A flow of the components A, B and X is provided by evaporating said components from the evaporation sources by heating at least the first, second and optionally the third evaporation source at a reduced pressure and/or by providing a gas flow of component A from the external source. Heating of the evaporation sources is done individually in order to better control the composition of the flow of the evaporated components. In one embodiment the first, second and third evaporation sources are individually heated at a temperature of 20-300°C, preferably 50-200°C. In one embodiment the third evaporation source is heated at a temperature of 20-150°C, preferably 50-100°C. In one embodiment the third evaporation source is arranged in an evaporation reactor and wherein the third evaporation source is not heated during evaporation. The reduced pressure during the evaporation is preferably lower than 5×10⁻⁴mbar, preferably lower than 1×10⁻⁴mbar, but preferably not lower than 1×10⁻⁵mbar.

The flow of the components is then brought into contact with the substrate surface in the deposition zone allowing said components to form the perovskite structure on the surface. Components of the first and the second evaporation source are preferably co-evaporated, and preferably also the components of the third evaporation source. The flow of the components is adjusted to obtain the wanted structure and composition on the substrate surface by adapting the heating temperature of the evaporation sources and the flow from the external source or the evaporation reactor. Preferably the flow rate or the deposition rate is monitored using at least one suitable detector arranged in the deposition zone, preferably one or more quartz crystal rate detectors or mass spectrometry. A control unit communicates with the detectors and communicates also with the heating devices for the evaporation sources and preferably also the pressure device adjusting the pressure in the vacuum chamber. In one embodiment, prior to deposition on the substrate surface the flow rate or deposition rate is monitored and when a stable or a preferred or predetermined flow rate or deposition rate has been reached the flow of the components are brought into contact with the substrate surface for deposition. The obtained substrate with the perovskite structure may then be further treated depending on the use of said substrate. In a preferred embodiment the obtained perovskite structure is annealed, preferably at a temperature of 30-150°C, more preferably 40-120°C.

In a preferred embodiment the component A-X of the at least one first evaporation source is selected from formamidinium iodide, formamidinium bromide, formamidinium chloride, methylammonium iodide, methylammonium bromide or methylammonium chloride or a combination of two or more thereof. In another preferred embodiment the component B-X of the at least one second evaporation source is selected from lead iodide (PbI₂), lead bromide (PbBr₂) or lead chloride (PbCl₂) or a combination of two or more thereof, or tin iodide (SnI₂ or SnI₄), tin bromide (SnBr₂ or SnBr₄) or tin chloride (SnCl₂ or SnCl₄) or a combination of two or more thereof. In yet another preferred embodiment a third evaporation source is provided and comprises component A as a salt where component A is the cation and the anion is selected from acetate, formate, tetrafluoroborate, hexafluorophosphate and thiocyanate. Preferably the salt is selected from formamidinium acetate or methylammonium acetate or a combination thereof and where the salt preferably is in the form of a powder. In one embodiment the third evaporation source is provided in an evaporation reactor in vapour connection with the deposition zone and the method preferably comprises a step of purifying the flow of the evaporated components from the third evaporation source prior to entering the deposition zone. An advantage of having the third evaporation source in an external evaporation reactor is that the flow rate or the deposition rate of the components A, B and X may more easily be individually adapted by adjusting the evaporation parameters such as the temperature and pressure. In one embodiment the gas from the external source or from the evaporation reactor is provided at an overpressure in relation to the wanted perovskite structure facilitating better control.

In one embodiment component X of the perovskite structure is a mixture of at least two halides, preferably iodide and bromide, and component A-X of the first evaporation source is preferably formamidinium bromide or methylammonium bromide and component B-X of the second evaporation source is preferably PbI₂. In another embodiment component A of the perovskite structure is a mixture of an organic molecule and one of caesium, potassium or rubidium, preferably caesium. A fourth evaporation source is preferably provided where the fourth evaporation source comprises component A and where said component A is an organic molecule or a mixture of organic molecules or a mixture of an organic molecule and caesium, potassium and/or rubidium with the proviso that component A is different from the component A of the first evaporation source. In one embodiment component A of the fourth evaporation source is caesium preferably as CsBr, caesium acetate or caesium format and where the first evaporation source preferably comprises the organic molecule preferably as formamidinium iodide, formamidinium bromide, formamidinium chloride, methylammonium iodide, methylammonium bromide or methylammonium chloride. The fourth evaporation source may be provided in the deposition zone or in an evaporation reactor in vapour connection with the deposition zone. The fourth evaporation source may be part of or mixed with the first or the second evaporation source.

The substrate may be any suitable substrate preferably made of silicon wafer, metallic or polymeric foil or glass. The substrate is preferably coated with a multi-layered structure including layers such as transparent conductive oxides (TCO) and hole or electron transport layers. During the present method the substrate may be heated or cooled using any suitable means in order to allow the components to condensate onto and/or react on the surface and to form perovskite. In one embodiment the substrate has a temperature lower than the temperature of the evaporated components in order to promote condensation of said components. In one embodiment the temperature of the substrate is 20-40°C. In one embodiment the present method is part of a process of preparing photovoltaic parts or components.

In order to describe the present method and the advantage of the same the preparation of a non-limiting perovskite having the structure of FAPbI₃ will be disclosed. This structure may be prepared by vacuum evaporation of FAI (formamidinium iodide) and PbI₂ according to prior art methods. If the two components are evaporated congruently at the same molecular rate the resulting film would ideally have the desired composition. However, it is difficult to control FAI evaporation since FA is dissociated and by-products disturb the process and lead to increased process pressure that limits the deposition rate due to scattering of the evaporating molecules and atoms. The sticking or deposition of dissociated components might be different and all components of the FAI might not be incorporated in the film at the same proportion, leading to off-stoichiometry of the perovskite material. Moreover CVD-like reactions may take place further complicating the perovskite film growth. Another complication is that iodine from the FAI is evaporated in the form of hydrogen iodide which is corrosive and toxic. All these vapor components may have different sticking or deposition properties on the growing film and as a result it becomes very difficult to control the composition of the perovskite material, not least because there is an interdependency between the amount of FA and I that leaves the FAI source. The current invention solves these issues by using an additional source of the organic molecule which do not contain any other of constituents of the perovskite structure. In this specific non-limiting example formamidinium acetate could be used as an evaporation source (third evaporation source) for formamidinium.

By evaporation of formamidinium acetate it is possible to add formamidinium molecules to the process without simultaneously adding iodine. Thus, it is possible to balance the amount of formamidinium added to the growing film with that of iodine, and by that way obtain the desired perovskite composition.

Evaporation of formamidinium acetate, has additional advantages compared to supplying all formamidinium from a FAI source. One is that the vapor pressure of formamidine above formamidinium acetate is relatively high and can be evaporated at lower temperature compared to formamidine from a FAI source. The lower temperature reduces the degree of dissociation of the formamidinium molecules, and the background pressure of non-desirable molecules can be kept low. The high vapor pressure does also facilitate a relatively small evaporating surface for a given formamidine flux. A convenient arrangement that utilizes this property is an external evaporation reactor or external source from which formamidine vapor is transported in a tube to the deposition zone. A further advantage with an external source or evaporation reactor is that the vapor can be purified before it is emitted into the deposition zone, thus reducing the level of impurities and non-desired molecular or atomic components in said zone and in the obtained structure.

In-line production of perovskite structure on substrate surfaces is possible with the present method which would then facilitate large scale production. In one embodiment the substrate enters the vacuum chamber via a substrate inlet and is transferred from said inlet via the deposition zone, for deposition of perovskite according to the present invention, to a substrate outlet to exit the vacuum chamber and where the transfer is done automatically.

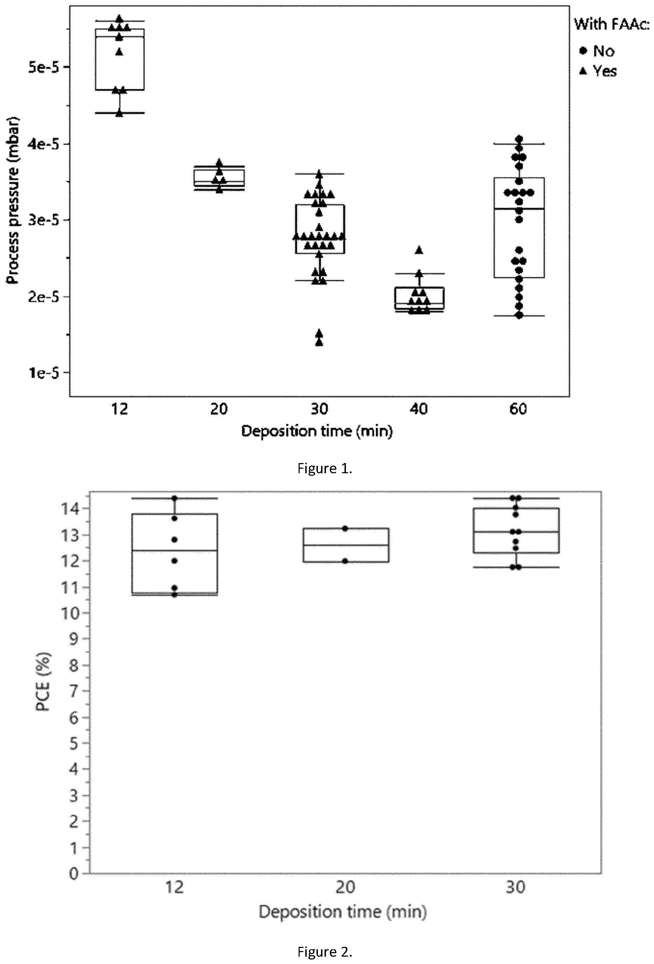

As is shown in the Examples and illustrated in Figure 1 and 2 the present invention facilitates a higher deposition rate and thereby a fast production without jeopardizing the quality of the obtained perovskite layer.

### The apparatus

According to the present invention the apparatus (10) is suitable for preparing a perovskite structure or a film of a perovskite structure as described above on a substrate surface (11) arranged in a vacuum chamber (12) in said apparatus. A substrate inlet (14) and a substrate outlet (16) are arranged in vacuum chamber (12) configured to allow a substrate to enter and exit the vacuum chamber respectively, and said substrate inlet and outlet are preferably equipped with a suitable closing device such as a vacuum load lock. The vacuum chamber (12) comprises at least one deposition zone (18) where at least one first evaporation source (20), at least one second evaporation source (22) and optionally also a third evaporation source (24) are arranged. First evaporation source (20) comprises component A-X, second evaporation source (22) comprises component B-X and third evaporation source comprises component A of the perovskite structure. The third evaporation (24) source may be arranged in an evaporation reactor (26) in vapour connection with the deposition zone (18) or component A is a gas provided in an external source (28) where said external source is in vapour connection with the deposition zone.

The vacuum chamber (12) is configured to allow the substrate to enter via the substrate inlet (14) and to be arranged in the deposition zone (18) in such a way that the flow of the components from the evaporation sources, the evaporation reactor and the external sources come into contact with the substrate surface, and wherein the vacuum chamber (12) is configured to allow the substrate to exit via the substrate outlet (16). A pressure device (36) is arranged in the apparatus configured to create and adjust the pressure in the vacuum chamber (12) and in the evaporation reactor (26) and said pressure device is preferably any suitable pump such as a vacuum pump.

An advantage of the present invention is that it allows in-line continuous production of perovskite. This is possible by allowing the substrate to enter the vacuum chamber via the substrate inlet and to be transferred from said inlet via the deposition zone for deposition of perovskite to the substrate outlet to exit the vacuum chamber automatically. Preferably the substrate inlet and the substrate outlet have a suitable closing device preferably vacuum load lock. In a preferred embodiment the at least one first evaporation source, the at least one second evaporation source, the third evaporation source or the evaporation reactor comprising the third evaporation source, or the external source are arranged along the transfer path of the substrate. Using evaporation reactor comprising the third evaporation source or external source comprising component A as a gas is beneficial in an in-line production since it requires less space in the deposition zone than the solid evaporation sources and allows higher flexibility regarding flow composition and flow optimization.

In order to evaporate the components from the first, second and third evaporation sources the vacuum chamber (12) and the optional evaporation reactor (26) comprise a heating device (29) configured to heat said sources individually and the pressure device (36) is configured to reduce the pressure in the vacuum chamber (12) and in the optional evaporation reactor (26). Using an evaporation reactor (26) for evaporating the third evaporation source (24) or an external source (28) for component A in gas phase has the advantage of that the flow of the component may be purified prior to entering the vacuum chamber and the deposition zone. When the third evaporation source (24) is arranged in an evaporation reactor (26), the apparatus preferably comprises a purifying device (30) configured to purify the vaporized components from the third evaporation source prior to entering the deposition zone. When an external source (28) comprising component A as a gas is provided in vapour connection with the deposition zone (18), the apparatus preferably comprises a purifying device (31) configured to purify the gas prior to entering the deposition zone. The purifying device (30) or (31) is preferably any suitable filter. Non-limiting examples of purifying device is a membrane gas separation device and a selective gas trapping material.

Depending on the composition of the evaporation sources the amount of heat needed to evaporate the components at the reduced pressure may vary. Heating of the evaporation sources is preferably done individually i.e. each evaporation source is individually heated and the heating device (29) may be any suitable heating device such as an electrical heater. The pressure device (36) is suitably arranged in order to create and main the reduced pressure in the vacuum chamber and in the optional evaporation reactor (26).

The apparatus (10) further comprises at least one detector (32) that is suitably arranged inside the vacuum chamber (12) and that is configured to measure or detect at least one property of the apparatus. The property is suitably a temperature, a pressure, a composition of evaporated components inside the vacuum chamber (12), or a property of the perovskite structure that is formed on the substrate. In some embodiments, a plurality of detectors (32) is arranged inside the vacuum chamber (12) and they may be configured to measure or detect the same property or different parameters. The apparatus (10) also suitably comprises a control unit (34) that is operatively connected to the at least one detector (32) so that signals may be transmitted from the at least one detector (32) to the control unit (34) and optionally also from the control unit (34) to the at least one detector (32).

Furthermore, the control unit (34) comprises processing circuitry that is suitably configured to control at least one property of the apparatus (10). In some embodiments, this is achieved by the control unit (34) being configured to control the heating device (29). In other embodiments, the control unit (34) may also or instead be configured to control supply of the third source from the evaporation reactor (26) or the external source (28) by operating a flow control device (not shown) such as a control valve or similar so that the flow of the third source or the external source is controlled. Also or alternatively, the control unit (34) may be configured to control pressure in the vacuum chamber (12) by e.g. operating the pressure device (36).

Thus, the control unit (34) serves to monitor at least one property in the vacuum chamber (12) and may also serve to control at least one property by operating any or all of the heating devices, vacuum pump and the supply of the third source. This has the advantage that conditions inside the vacuum chamber (12) can be controlled so that a desired quality of the produced perovskite is achieved.

Non-limiting suitable detectors are quartz crystal rate detectors and mass detectors such as mass spectrometer. Quartz crystal rate detectors are preferably arranged so that each detector only detects the flow from one evaporation source. When using an external source or an evaporation reactor a mass spectrometer is preferably used. By monitoring the composition of the flow versus time the structure of the perovskite may be controlled especially in an in-line production where the evaporation sources, the evaporation reactors and external sources are arranged along the transfer path of the substrate.

The vacuum chamber (12) is preferably further configured to anneal the obtained perovskite structure on the substrate surface. In one embodiment the vacuum chamber is configured to heat the obtained perovskite structure to a temperature of 30-150°C.

### EXAMPLES

### Example 1

Thin films perovskite solar cell absorber layers with the elemental composition FA_{1-*x*}Cs*ₓ*Pb_{y}I_{2*-x+y*}Br*ₓ* (x = 0.30±0.05, y = 1.1±0.1) were deposited on NiO-coated glass substrates by thermal co-evaporation of Pbb, CsBr, and formamidinium iodide (FAI), all in form of a powder, with a resulting film thickness of 0.6±0.1 µm. An additional supply of formamidinium acetate (FAAc) was optionally provided as an additional source of formamidinium, to compensate for loss of formamidine by decomposition. All film depositions were performed as follows. Estimated evaporation temperatures are PbI₂ around 300°C, CsBr around 450°C, FAI around 150°C and FAAc around 80°C.

The process was initiated at a base pressure of <2×10⁻⁶ mbar. For depositions utilizing FAAc, a 1×10⁻⁵ mbar partial pressure of FAAc was supplied via an external source, consisting of a stainless-steel bottle heated to 80±5 °C. The gas-inlet port was not directed towards the substrate.

Evaporation of Pbb, CsBr, and FAI started by gradually increasing the power to the heaters surrounding the source crucibles, which were positioned below and in line-of-sight of the substrate. The evaporation rates were stabilized for 25 minutes during which the substrate shutter remained closed. The individual evaporation rates of the constituents, and thus also film composition, were controlled by means of quadrupole mass spectrometry feedback. After evaporation rate stabilization, the substrate shutter was opened, and film deposition started. The deposition rates were adjusted to achieve a film thickness of 0.6±0.1 µm in a deposition time of 12, 20, 30, 40, or 60 minutes. The substrate shutter was then closed, and the source heaters were turned off. After perovskite deposition, the composition was determined by X-ray fluorescence and/or further processed into solar cell devices by deposition of a C60/In₂Oₓ:Zn transparent electron-selective contact.

The process pressure is higher for processes with higher deposition rates due to the fact that evaporated species, both desired and non-desired dissociation products, forms a background pressure in the vacuum chamber. This is shown in Figure 1, which shows the measured process pressure for different deposition times. Each data point corresponds to one deposition. More importantly, Figure 1 also shows the effect of the FAAc addition. Without FAAc supply, the measured process pressures were around 2-4×10⁻⁵ mbar for the 60 minute process. By supplying 1×10⁻⁵ mbar of FAAc, it was possible to significantly increase the depositions rate while maintaining (or lower) the process pressure.

Decreasing the deposition time from 30 minutes to 12 minutes, by increasing the deposition rate, does not necessarily lower the power conversion efficiency (PCE) of the solar cell devices. This is shown in Figure 2 and Table 1, which include PCE values, measured under standard test conditions, for solar cell devices fabricated using perovskite absorber layers deposited in the described process, using a sputtered transparent conducting oxide as top electrode with an evaporated C60 buffer layer in-between.

**Table 1. Solar cell IV measurement data for solar cells manufactured with the described perovskite deposition process (with FAAc addition).**

| Deposition time (min) | PCE (%) | Voc (mV) | Jsc (mA/cm2) | FF | Area (cm2) |
|---|---|---|---|---|---|
| 12 | 14.4 | 1067 | 18.0 | 0.75 | 0.126 |
| 20 | 14.2 | 1028 | 17.7 | 0.73 | 0.126 |
| 30 | 14.4 | 1056 | 17.9 | 0.76 | 0.126 |

## Claims

1. A method of preparing a perovskite structure on a substrate surface wherein the perovskite has a general structure of ABX₃ where component A is an organic molecule or a mixture of organic molecules, or wherein A is caesium, potassium and/or rubidium or a mixture of an organic molecule and caesium, potassium and/or rubidium, component B is lead and/or tin and component X is a halide, and wherein the method comprises the steps of:
a. Providing the substrate in a deposition zone in a vacuum chamber;
b. Providing at least a first and a second evaporation source of the components, wherein the first evaporation source comprises component A-X and the second evaporation source comprises component B-X, and wherein a third source is provided wherein the third source is either a third evaporation source comprising component A as a salt or wherein the third source is an external source containing a gas comprising component A, wherein the salt comprises the organic molecule or mixture of organic molecules as the cation and wherein the anion is not a halide and wherein the gas contained in the external source comprises formamidine, formamidinium, methylammonium or methylamine;
c. Providing a flow of the components A, B and X in gas phase by evaporating said components by heating the first and the second evaporation sources at a reduced pressure and by evaporating component A from the third evaporation source at the reduced pressure or by providing a flow of the gas from the external source;
d. Bringing the flow of the components A, B and X into contact with the substrate surface in the deposition zone and allowing the components to form a perovskite structure on said surface.

2. The method according to claim 1 wherein the component A-X and B-X of the first and second evaporation sources respectively are solid when heated preferably in the form of a powder.

3. The method according to claim 1 or 2 wherein the component A-X of the first evaporation source is selected from formamidinium iodide, formamidinium bromide, formamidinium chloride, methylammonium iodide, methylammonium bromide or methylammonium chloride or a combination of two or more thereof.

4. The method according to any one of claims 1 to 3 wherein the component B-X of the second evaporation source is selected from lead iodide (PbI₂), lead bromide (PbBr₂) or lead chloride (PbCl₂) or a combination of two or more thereof, or from tin iodide (SnI₂ or SnI₄), tin bromide (SnBr₂ or SnBr₄) or tin chloride (SnCl₂ or SnCl₄) or a combination of two or more thereof.

5. The method according to any of the preceding claims wherein the third evaporation source is provided and comprises component A as a salt wherein the anion is selected from acetate, formate, tetrafluoroborate, hexafluorophosphate and thiocyanate, and wherein the salt is preferably selected from formamidinium acetate or methylammonium acetate or a combination thereof and wherein the salt preferably is in the form of a powder.

6. The method according to any one of claim 1 to 4 wherein the external source is provided containing a gas comprising component A and wherein the gas is purified prior to entering the deposition zone.

7. The method according to any of the preceding claims wherein the method further comprises providing a fourth evaporation source wherein the fourth evaporation source comprises component A-X wherein A is caesium, potassium and/or rubidium, wherein A-X is preferably selected from caesium-acetate, caesium-formate, caesium iodide (Csl) and caesium bromide (CsBr) and evaporating the component of the fourth evaporation source at the reduced pressure by heating the fourth evaporation source to create a flow of said components and bringing the flow of the evaporated components into contact with the substrate surface in the deposition zone and allowing the components to form a perovskite structure on said surface.

8. The method according of any of the preceding claims wherein the reduced pressure in the deposition zone is lower than 1×10⁻⁴mbar.

9. The method according to any of the preceding claims wherein the substrate has a multi-layered structure including preferred layers such as transparent conductive oxides (TCO) and hole or electron transport layers.

10. The method according to any of the preceding claims wherein the third evaporation source is arranged in an evaporation reactor in vapour connection with the deposition zone; and wherein the method preferably comprises a step of purifying the flow of the evaporated components from the third evaporation source prior to entering the deposition zone.

11. An apparatus for preparing a perovskite structure (10) on a substrate surface (11) wherein the perovskite has a general structure of ABX₃ where component A is an organic molecule or a mixture of organic molecules, or wherein A is caesium, potassium and/or rubidium or a mixture of an organic molecule and caesium, potassium and/or rubidium, component B is lead and/or tin and component X is a halide,
and wherein the apparatus comprises a vacuum chamber (12) comprising a substrate inlet (14) and a substrate outlet (16);
wherein the vacuum chamber comprises at least one deposition zone (18) wherein at least a first (20) and a second evaporation source (22) of the components are arranged, wherein the first evaporation source (20) comprises component A-X, the second evaporation source (22) comprises component B-X;
wherein a third source is provided wherein the third source is either a third evaporation source (24) comprising component A as a salt provided in the deposition zone (18) or in an evaporation reactor (26) in vapour connection with the deposition zone of the vacuum chamber, or wherein the third source is an external source (28) containing a gas comprising component A provided in vapour connection with the deposition zone, and wherein the salt comprises the organic molecule or mixture of organic molecules as the cation and wherein the anion is not a halide and wherein the gas contained in the external source (28) comprises formamidine, formamidinium, methylammonium or methylamine; and
wherein the vacuum chamber (12) and the optional evaporation reactor (26) comprise a heating device (29) configured to heat the evaporation sources individually at a reduced pressure to vaporize the components and to create a flow of said components, and wherein the vacuum chamber is configured to bring the flow into contact with the substrate surface.

12. The apparatus according to claim 11 wherein the vacuum chamber is configured to enable one or more substrates to enter and exit the vacuum chamber automatically via the substrate inlet (14) and the substrate outlet (16) respectively.

13. The apparatus according to claim 11 or 12 wherein the apparatus is configured to enable in-line continuous production of perovskite structures on a substrate surface by enabling the substrate to enter the vacuum chamber via the substrate inlet and to be transferred from said inlet via the deposition zone to a substrate outlet to exit the vacuum chamber.

14. The apparatus according to any one of claim 11 to 13 wherein the third evaporation source (24) is arranged in an evaporation reactor (26) and wherein the apparatus preferably comprises a purifying device (30) configured to purify the vaporized components from the third evaporation source prior to entering the deposition zone.

15. The apparatus according to claim 11 wherein an external source (28) containing a gas comprising component A is provided in vapour connection with the deposition zone and wherein the apparatus preferably comprises a purifying device (31) configured to purify the gas prior to entering the deposition zone.

16. The apparatus according to any of claim 11 to 15, further comprising at least one detector (32) and a control unit (34) that is operatively connected to the at least one detector (32), wherein the at least one detector (32) is configured to detect or measure at least one property of the apparatus and to transmit signals representing the at least one property to the control unit (34), and wherein the control unit (34) is configured to control at least one of the heating device (29), the pressure device (36) or a flow control device for the evaporation reactor (26) or the external source (28).

17. The apparatus according to claim 16 wherein the detector (32) is a quartz crystal microbalance rate sensor.

18. The method according to any one of claims 1 to 10 wherein the flow of the components is monitored using at least one suitable detector arranged in the deposition zone preferably by using one or more quartz crystal rate detectors or mass spectrometry.

19. The method according to any one of claims 1 to 10 wherein the components of at least the first, the second evaporation sources and preferably also the third evaporation source are co-evaporated.

20. The method according to any one of claims 1 to 10 wherein the substrate has a temperature lower than the temperature of the components of the flow.
